# FASCICULE DE BREVET EUROPEEN

(11) **EP 2 336 800 B1**
(45) Date de publication et mention de la délivrance du brevet: **11.07.2012**
(21) Numéro de dépôt: 10194905.5
(22) Date de dépôt: 14.12.2010
(51) Int. Cl.: G01S 1/00, G01S 19/21

(54) **Procédé et récepteur pour supprimer un signal de brouillage**
Verfahren und Empfänger zur Unterdrückung eines Störsignals
Method and receiver for jammer suppression

(30) Priorité: 15.12.2009 FR 0906083
(43) Date de publication de la demande: 22.06.2011
(73) Titulaire: SAGEM DEFENSE SECURITE, 75015 Paris (FR)
(72) Inventeur: Le Liboux, Jean-Christophe, 75015, PARIS (FR); Descomps, Nicolas, 75015, PARIS (FR); Luneau, Ghislain, 75015, PARIS (FR)
(74) Mandataire: Callon de Lamarck, Jean-Robert

(56) Documents cités:
- US-A1- 2007 025 479
- US-B1- 7 324 037
- FRANK AMOROSO: "Adaptive A/D Converter to Suppress CW Interference in DSPN Spread Spectrum Communications", MILITARY COMMUNICATIONS CONFERENCE, 1983. MILCOM 1983. IEEE, IEEE, PISCATAWAY, NJ, USA, 31 octobre 1983 (1983-10-31), pages 720-728, XP031433101,
- Deshpande, Cannon: "Interference Effects on the GPS Signal Acquisition", National Technical Meeting, Institute of Navigation , 28 janvier 2004 (2004-01-28), pages 1-11, XP002597057, Extrait de l'Internet: URL:http://ion-alberta.org/papers/04ntmsde shpande.pdf [extrait le 2010-08-18]

## Description

### DOMAINE TECHNIQUE GENERAL

La présente invention concerne un procédé de réduction d'un signal de brouillage d'un signal à large bande à étalement de spectre à destination d'un récepteur, le récepteur comportant un système de réduction du signal de brouillage comportant un contrôleur de gain automatique.

Elle concerne également un récepteur de mise en oeuvre du procédé.

L'invention s'applique avantageusement mais non limitativement aux signaux à large bande à étalement de spectre du type GPS (Global Positioning System) ou GNSS (Global Navigation Satellite System) selon la terminologie anglo-saxonne généralement utilisée par l'homme du métier.

### ETAT DE L'ART

Le principe connu de localisation GPS (ou GNSS) utilise des mesures de signaux radioélectriques reçus d'une constellation de satellites.

La distance importante des satellites à la Terre, ainsi que les techniques d'étalement de spectre utilisées, impliquent que les signaux radioélectriques reçus à la surface de la Terre sont de très faible puissance (-130 dBm, soit 10⁻¹⁶ Watt).

Les signaux GPS sont donc très sensibles aux brouillages (intentionnels ou pas) provenant d'autres équipements radioélectriques.

Les brouillages peuvent par exemple être une émission hors bande d'un émetteur de télévision dans les fréquences du GPS, ou un brouilleur de fort niveau sur un terrain d'opérations militaires.

Des techniques connues existent à ce jour pour améliorer la tenue au brouillage des récepteurs GPS.

Parmi les techniques connues, il existe des techniques analogiques, ou des techniques de numérisation sur un bit, mais la plus avantageuse est la numérisation sur deux bits, également appelée conversion ou numérisation non-uniforme.

La numérisation sur deux bits permet de recevoir les signaux GPS, malgré la présence de brouillage de forme sinus ou « continuous wave » (CW) selon la terminologie anglo-saxonne généralement utilisée par l'homme du métier.

On explique ici la mise en oeuvre de la numérisation sur deux bits.

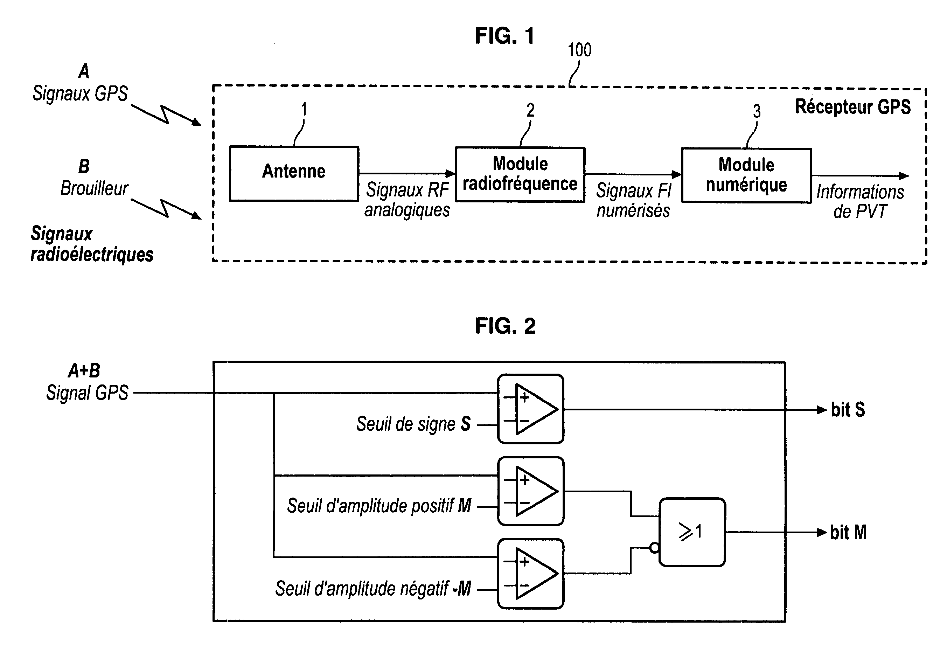

Comme le montre la figure 1, un récepteur 100 de localisation GPS est classiquement principalement constitué de trois éléments, à savoir :
- une antenne 1,
- un module 2 radiofréquence, et
- un module 3 numérique.

Le module 2 radiofréquence est situé entre l'antenne 1 et le module 3 numérique.

Le module radiofréquence 2 comporte généralement un système 20 de réduction du brouillage.

Comme le montre la figure 2, la numérisation sur deux bits précitée consiste à créer, à partir d'un signal GPS brouillé, comportant le signal GPS A et le signal B de brouillage, deux bits par comparaison à des seuils.

Le premier bit est appelé « bit de signe » et est référencé par S.

Le deuxième bit est appelé « bit d'amplitude » et est référencé par M.

Le seuil du bit M est ajustable en fonction du type de signal A.

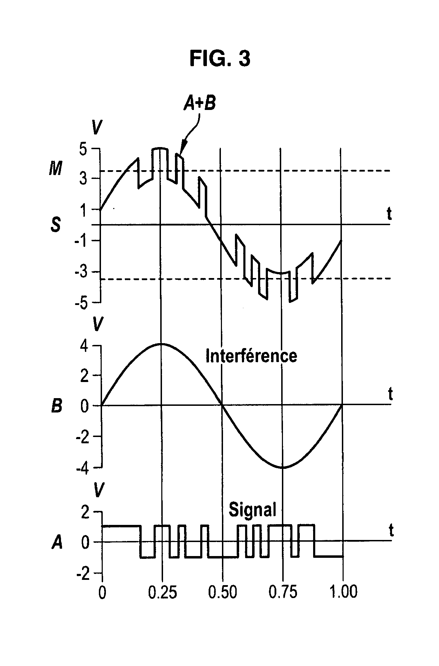

Comme le montre la figure 3, lorsque le signal B est du type CW, la numérisation connue permet de récupérer le signal A à partir du signal A+B, notamment grâce à la création du bit M.

La numérisation sur plus de deux bits est également connue.

La technique connue de conversion ou numérisation sur au moins deux bits présente des avantages.

Sous un fort brouillage de type CW, et par rapport à une solution analogique, la numérisation sur un bit peut dégrader le rapport signal à bruit de près de 7dB.

Au contraire, sous ce même brouilleur CW, la numérisation sur deux bits permet d'améliorer très significativement le rapport signal à bruit. Le rapport signal à bruit est alors optimal si l'on ignore en sortie du convertisseur de bits les échantillons pour lesquels le bit M n'est pas activé, ce qui revient à ne numériser le signal que sur 1,5 bit. Ainsi, sous fort brouillage de type CW, et par rapport à une solution analogique, la numérisation sur 1,5 bit peut améliorer le rapport signal à bruit de plus de 10 dB, lorsque le rapport cyclique d'activité du bit M est fixé, par exemple, à 20%.

Par ailleurs, sous brouillage gaussien et par rapport à une solution analogique, la numérisation sur deux bits permet de limiter la dégradation du rapport signal à bruit à moins de 0.6 dB, contre 1.96 dB pour une numérisation sur un bit.

La numérisation sur deux bits présente cependant des inconvénients.

Il existe en effet une façon plus subtile de brouiller les signaux GPS que de les brouiller avec un signal de type CW, dont l'énergie forme une raie dans un spectre de réception des signaux GPS, et dont l'amplitude crête est également constante. Une solution de brouillage est ainsi d'adopter un brouilleur gaussien dans une bande élargie. L'énergie du signal de brouillage va ainsi s'étaler dans le spectre de réception des signaux GPS, avec des fluctuations rapides de l'amplitude crête du signal de brouillage, et donc être plus difficile à rejeter.

On connaît de US 7 324 037 une technique de rejection des signaux de brouillage de type CW. Mais cette technique ne permet pas de traiter les brouilleurs de type gaussien.

US 2007/0025479 divulgue un GAS avec une interface numérique universelle.

### PRESENTATION DE L'INVENTION

L'invention propose de pallier au moins un de ces inconvénients.

A cet effet, on propose selon l'invention un procédé de réduction d'un signal de brouillage selon la revendication 1.

L'invention est avantageusement complétée par les caractéristiques de l'une des revendications 2 à 5.

L'invention concerne également un récepteur de mise en oeuvre du procédé précité.

L'invention présente de nombreux avantages.

L'invention permet de rejeter un signal de bruitage qui n'est pas du type sinus (CW).

La présente invention permet une réduction du signal de brouillage dit de bande étroite, typiquement de bande jusqu'à 100 kHz.

L'invention s'applique aux signaux large bande à étalement de spectre, par exemple de type CDMA (en anglais « Code Division Multiple Access », à savoir un accès multiple par répartition en code) connu de l'homme du métier, typiquement mais non limitativement à des signaux GPS/GNSS, qu'ils soient en modulation BPSK (en anglais « Binary Phase Shift Keying », à savoir une modulation binaire par déplacement de phase) ou BOC (en anglais « Binary Offset Carrier », à savoir une porteuse binaire décalée) et dérivées.

L'invention permet un gain maximal de réduction des brouilleurs bande étroite, typiquement de bande jusqu'à 100 kHz.

### PRESENTATION DES FIGURES

D'autres caractéristiques, buts et avantages de l'invention ressortiront de la description qui suit, qui est purement illustrative et non limitative, et qui doit être lue en regard des dessins annexés sur lesquels :
- la figure 1, déjà commentée, représente schématiquement un récepteur de signaux large bande du type GPS ;
- les figures 2 et 3, déjà commentées, représentent schématiquement une technique connue de réduction de brouillage par numérisation sur deux bits ;
- la figure 4 représente schématiquement un récepteur selon l'invention comportant un contrôleur de gain automatique, et optionnellement un pondérateur ;
- la figure 5 représente schématiquement une vue plus détaillée du contrôleur de la figure 4 comportant un détecteur ;
- la figure 6 est une vue plus détaillée du détecteur de la figure 5 ;
- la figures 7 représente schématiquement une vue plus détaillée d'un convertisseur selon la figure 6 ;
- la figure 8 est une courbe représentant schématiquement la densité de probabilité du signal de brouillage en fonction de l'amplitude pour un signal de brouillage en fonction de l'amplitude, d'une part pour un signal de brouillage du type CW et d'autre part pour un signal de brouillage à bande étroite ; et
- la figure 9 représente schématiquement une vue plus détaillée du pondérateur de la figure 4.

Sur l'ensemble des figures, les éléments similaires portent des références numériques identiques.

### DESCRIPTION DETAILLEE

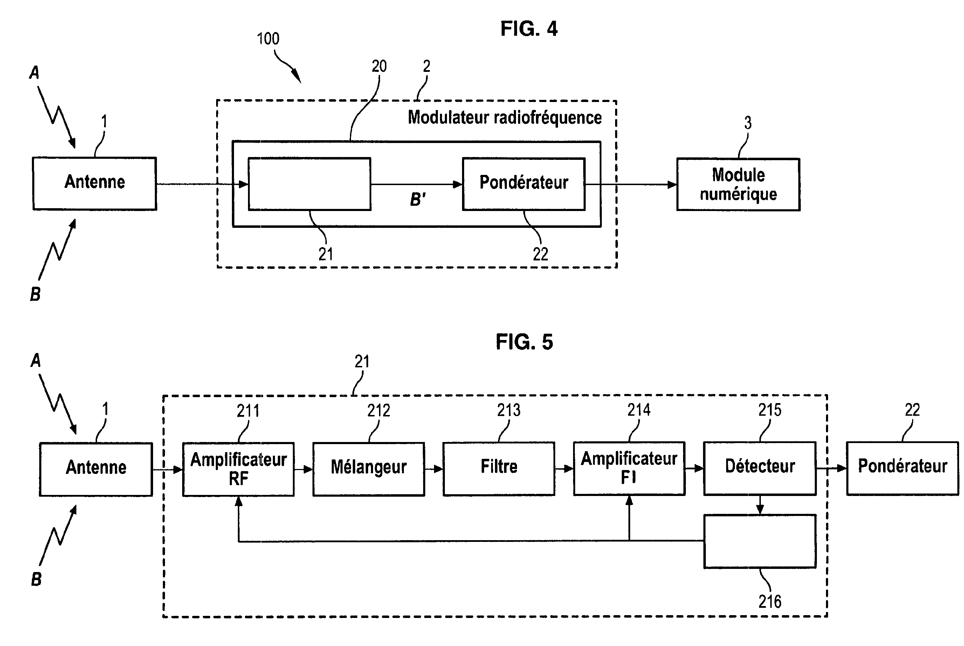

Les figures 4 à 9 représentent schématiquement un mode de mise en oeuvre possible d'un procédé de réduction d'un signal B de brouillage d'un signal A large bande à spectre étalé.

Le signal A est un signal à étalement de spectre, par exemple de type CDMA (en anglais « Code Division Multiple Access », à savoir un accès multiple par répartition en code) ou FDMA (en anglais « Frequency Division Multiple Access », à savoir un accès multiple par répartition en fréquence), connus de l'homme du métier, typiquement mais non limitativement un signal GPS ou GNSS, en modulation BPSK (en anglais, Binary Phase Shift Keying) ou BOC (en anglais, Binary Offset Carrier) et dérivées.

Le signal A est généré classiquement par une modulation d'une porteuse radiofréquence par un signal composite. On répète que la modulation peut être préférentiellement à deux états de phase, selon la technique BPSK connue de l'homme du métier. Le signal A est ainsi la somme d'un signal à basse fréquence (typiquement 50 bits/s) avec une séquence d'étalement pseudo-aléatoire haute fréquence (typiquement multiple entier de 1,023 Mbits/seconde). On répète que le signal peut également être modulé par une sous-porteuse, selon les techniques BOC et dérivées, connues de l'homme du métier.

Le signal A est destiné à un récepteur 100.

Comme le montre schématiquement la figure 4, le récepteur 100 comporte principalement une antenne 1 et un module 2 radiofréquence monté en sortie de l'antenne 1.

La sortie du module 2 est envoyée à un module 3 numérique.

Le module 2 comporte un système 20 de réduction du signal B de brouillage.

Le système 20 comporte principalement un contrôleur 21 de gain automatique.

Le contrôleur 21 est décrit plus précisément à la figure 5.

Le contrôleur 21 traite l'ensemble des signaux entrants, à savoir le signal A et le signal de brouillage B.

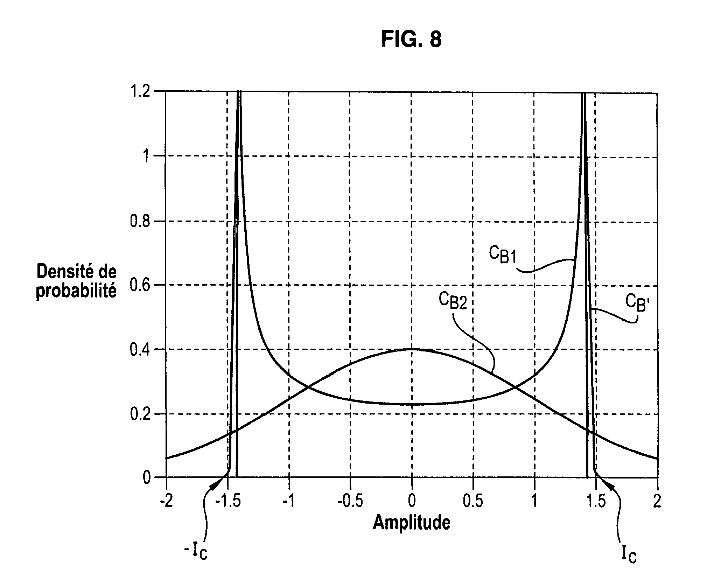

Le signal B de brouillage peut typiquement être de deux types, comme le montre schématiquement la figure 8.

Le premier type, référencé par B1, est un signal de brouillage sinusoïdal, également appelé CW (ou « Continuous Wave »). Le signal B1 ne présente qu'une raie discrète à une fréquence donnée dans un spectre de réception, et présente une courbe C_{B1} de densité de probabilité d'amplitude instantanée bornée entre deux valeurs d'une amplitude de crête [-lc ; lc].

Le deuxième type de signal de brouillage, référencé par B2, est un signal appelé bande étroite, car il occupe une bande de largeur donnée dans un spectre de réception (en général la largeur est inférieure à 100 kHz). Le signal B2 a une courbe C_{B2} de densité de probabilité de forme gaussienne.

On comprend qu'un signal B1 de type CW a la propriété de présenter une enveloppe constante et bornée entre [-lc ; lc] (l'amplitude de crête instantanée du signal B1 est constante dans le temps), alors qu'un signal B2 bande étroite présente une enveloppe pseudo-aléatoire.

Selon l'invention, le contrôleur 21 permet de transformer une courbe C_{B2} de densité de probabilité d'un signal bande étroite de forme gaussienne en celle d'un signal de brouillage du type CW.

A cet effet, le contrôleur 21 effectue en continu une normalisation d'une amplitude de crête instantanée du signal B, de sorte que ladite amplitude de crête instantanée soit constante dans le temps pour le signal ainsi normalisé.

De cette façon et comme le montre la figure 8, une courbe C_{B}^{,} de densité de probabilité d'amplitude instantanée du signal B' normalisé est bornée entre deux valeurs d'une amplitude de crête [-lc ; lc].

Le signal B' de brouillage normalisé est converti en signal de brouillage sinusoïdal lorsque le signal de brouillage B est à bande étroite, c'est-à-dire avec une largeur de bande jusqu'à 100kHz.

En revanche, le signal B' de brouillage normalisé reste sous la forme d'un signal de brouillage gaussien lorsque le signal de brouillage B a une largeur de bande supérieure à une bande étroite, c'est-à-dire supérieure à 100kHz.

Cette normalisation va permettre au système 20 d'effectuer un traitement de numérisation sur deux bits non-uniformes déjà décrit, comme pour un brouillage du type CW.

On constate que le contrôleur 21 comporte, préférentiellement dans cet ordre :
- un amplificateur 211 radiofréquence RF ;
- un mélangeur 212,
- un filtre 213,
- un amplificateur 214 de fréquence intermédiaire,
- un détecteur 215, et
- une commande 216.

L'amplificateur 211 et/ou l'amplificateur 214 comporte un gain variable qui peut être commandé par la commande 216, branchée à cet effet en sortie du détecteur 215.

Le mélangeur 212 réalise une transposition en fréquence des radiofréquences RF vers des fréquences intermédiaires Fl.

Le contrôleur 21 comporte également un oscillateur local non représenté alimentant le mélangeur 212.

Le filtre 213 est un filtre de canal utilisant la technologie à ondes de surfaces. Le filtre 213 est donc par conception limité en fréquence et présente un temps de propagation de groupe élevé, à savoir de l'ordre de 700 ns. Il est cependant nécessaire à la bonne réception des signaux A.

Ainsi, pour contrecarrer le temps de propagation relativement élevé du filtre 213, le gain de l'amplificateur 211 et le gain de l'amplificateur 214 sont commandés par la commande 216. La bande passante de l'amplificateur 211 1 et la bande passante de l'amplificateur 214 sont de préférence supérieures à 100 kHz, ce qui permet d'atténuer le retard du filtre 213.

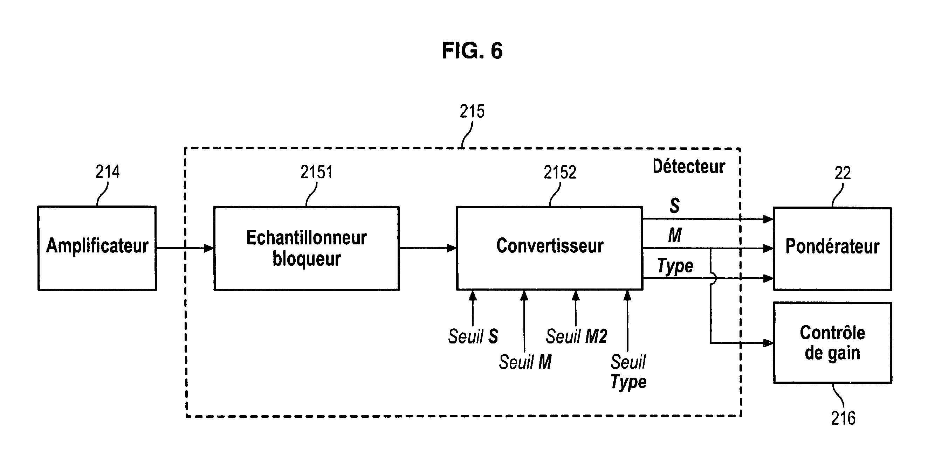

Le détecteur 215 est plus précisément représenté à la figure 6.

Il comporte un échantillonneur bloqueur 2151 dont la sortie est branchée en entrée d'un convertisseur analogique/numérique 2152.

Le convertisseur 2152 numérise sur deux bits le signal issu de l'échantillonneur bloqueur, et élabore également un bit de type qui diffère selon que ce signal B' normalisé est gaussien ou sinusoïdal. On rappelle en effet que
- le signal B' de brouillage normalisé est converti en signal de brouillage sinusoïdal lorsque le signal de brouillage B est à bande étroite, c'est-à-dire avec une largeur de bande jusqu'à 100kHz, mais que
- le signal B' de brouillage normalisé reste sous la forme d'un signal de brouillage gaussien lorsque le signal de brouillage B a une largeur de bande supérieure à une bande étroite, c'est-à-dire supérieure à 100kHz.

En entrée du convertisseur 2152, on branche un seuil S dont la valeur est fixée à 0, un seuil M, un seuil d'amplitude auxiliaire M2 et un seuil de type. Le détecteur 215 permet ainsi de réaliser l'extraction
- des bits de signe S,
- des bits d'amplitude M, et
- des bits de type.

Le rapport cyclique d'activité du bit M est maintenu constant par une boucle de contrôle de gain, non représentée, qui ajuste le niveau d'entrée de l'échantillonneur bloqueur 2151.

L'échantillonneur bloqueur 2151 respecte les règles de conversion des signaux, et le critère de Nyquist-Shannon.

Le convertisseur 2152 est ainsi un convertisseur à base de comparateurs dont les seuils précités sont fixes.

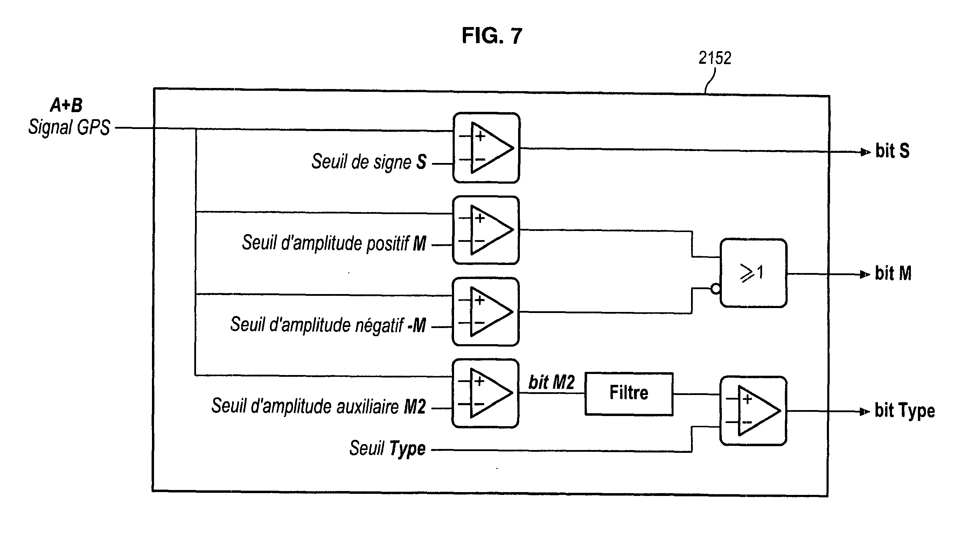

Comme le montre la figure 7, le seuil S et le seuil M permettent la numérisation sur deux bits du signal entrant, avec extraction des bits de signe S et des bits d'amplitude M.

Le seuil d'amplitude auxiliaire M2 sert à l'extraction d'un bit d'amplitude auxiliaire M2, en vue de l'élaboration du bit de type. Le seuil M2 est placé relativement au seuil M. Le seuil M2 sélectionné est inférieur au seuil M.

Le bit de type est obtenu en mesurant le rapport cyclique d'activité du bit M2. Précisément, le bit de type est obtenu en comparant le bit d'amplitude auxiliaire M2 filtré passe-bas, et le seuil de type.

Le seuil de type sélectionné a une valeur comprise entre la valeur théorique du rapport cyclique d'activité du bit M2 obtenue lorsque le signal entrant présente une densité de probabilité de type gaussienne, et la valeur théorique du rapport cyclique d'activité du bit M2 obtenue lorsque le signal entrant présente une densité de probabilité de type CW. Ces valeurs théoriques sont connues de l'homme du métier.

Ainsi, en sortie du convertisseur 2152, le comportement du bit de type est alors le suivant :
- lorsque le signal entrant est de type gaussien, le bit M2 filtré est inférieur au seuil de type, et le bit de type prend la valeur 0.
- lorsque le signal entrant est de type CW, le bit M2 filtré est supérieur au seuil de type, et le bit de type prend la valeur 1.

Comme on peut le constater sur la figure 6, seul le bit M est utilisé par la commande de gain 216, pour fermer la boucle d'asservissement du gain mise en oeuvre dans le contrôleur 21.

Le contrôleur 21 est dit rapide, car il est capable de suivre la vitesse de variation de l'amplitude du signal de brouillage B entrant. La bande passante du contrôleur 21 est supérieure à 100 kHz. Toute variation d'amplitude à fréquence inférieure à la fréquence de coupure du contrôleur 21 sera normalisée, et sera donc à amplitude de crête instantanée constante.

Avantageusement, et comme le montrent les figures 4 à 6 par exemple, le système 20 peut comporter en outre un pondérateur 22 en sortie du contrôleur 21, en amont du module 3.

Le pondérateur 22 a pour fonction d'optimiser la pondération du signal normalisé et numérisé. Le pondérateur 22 a pour but de rejeter les échantillons de signaux A+B contenant trop peu de signal A et trop de bruit B. Le pondérateur accentue alors la normalisation lorsqu'un brouilleur du type CW ou bande étroite brouille le signal A.

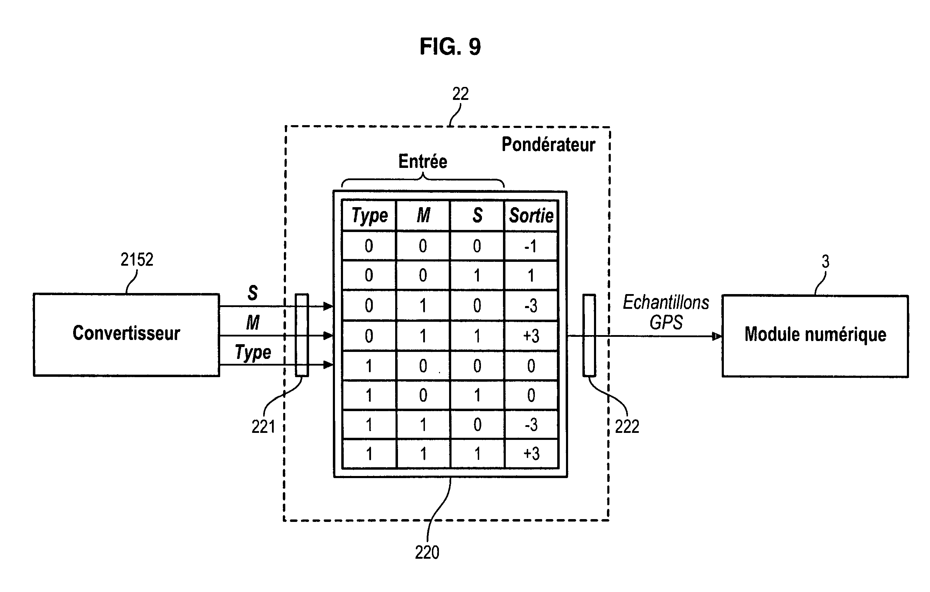

Comme le montre la figure 9, le pondérateur 22 comporte donc un module 221 de type de signal B de brouillage et un module 222 de pondération des échantillons.

Le pondérateur 22 utilise, grâce au module 221, le bit de type issu du convertisseur 2152 pour modifier les poids des bits d'amplitude M et de signes S.

La modification des poids s'effectue, grâce au module 222, à l'aide d'une table 220 d'allocations représentée à la figure 8 mémorisée dans le pondérateur 22.

Le bit de type issu du convertisseur 2152 présente le comportement suivant :
- il est égal à 0 si le signal entrant présente une densité de probabilité gaussienne (on dit que le bit de type est gaussien) ;
- il est égal à 1 si le signal entrant présente une densité de probabilité de type CW (on dit que le bit de type est sinusoïdal).

On comprend que la densité de probabilité de type CW peut provenir directement d'un signal de type CW ou être issue d'un signal de type bande étroite traité par le contrôleur 21.

Les échantillons entrant dans le module numérique 3 voient leur pondération modifiée en fonction du type du signal entrant :
- si le signal entrant est de type gaussien, la pondération est celle de la numérisation deux bits classique;
- si le signal entrant est de type CW, la pondération est ramenée à celle d'une numérisation 1.5 bit.

Les échantillons entrant dans le module numérique 3 voient leurs poids modifiés en fonction du type du signal entrant :
- les coefficients de pondération de la table 220 d'allocation sont égaux à
   -3, -1, +1,ou +3
   si le signal entrant est de type gaussien, c'est-à-dire pour une pondération d'une numérisation sur deux bits ; et
- ils sont égaux à
   -3, 0, 0, ou +3
   si le signal entrant est de type CW, c'est-à-dire pour une pondération d'une numérisation sur 1.5 bit.

## Revendications

1. Procédé de réduction d'un signal (B) de brouillage d'un signal (A) à large bande à étalement de spectre à destination d'un récepteur (100),
le récepteur (100) comportant un système (20) de réduction du signal (B) de brouillage comportant
- un contrôleur (21) de gain automatique comportant
au moins un amplificateur (211, 214) et une commande de gain (216), et
un convertisseur (2152) analogique/numérique, et
- un pondérateur (22) placé en sortie du contrôleur (21),
ledit procédé étant **caractérisé en ce que**
- le contrôleur (21) traite l'ensemble des signaux entrants, à savoir le signal (A) à large bande à étalement de spectre et le signal de brouillage (B) et effectue en continu une normalisation d'une amplitude de crête instantanée de l'ensemble des signaux entrants, de sorte que ladite amplitude de crête instantanée soit constante dans le temps pour l'ensemble des signaux ainsi normalisés,
- le signal (B') de brouillage normalisé étant ainsi converti en signal de brouillage sinusoïdal lorsque le signal de brouillage (B) est à bande étroite,
- le signal (B') de brouillage normalisé restant sous la forme d'un signal de brouillage gaussien lorsque le signal de brouillage (B) a une largeur de bande supérieure à une bande étroite,
- le convertisseur (2152) du contrôleur (21)
effectue d'une part une numérisation sur au moins deux bits de l'ensemble des signaux normalisés à savoir élabore un bit de signe (S) et au moins un bit d'amplitude (M), et
élabore d'autre part un bit de type qui diffère selon que le signal de brouillage normalisé (B') est gaussien ou sinusoïdal,
le bit de type étant un bit gaussien lorsque le signal (B') de brouillage normalisé est sous la forme d'un signal de brouillage gaussien,
le bit de type étant un bit sinusoïdal lorsque le signal (B') de brouillage normalisé est sous la forme d'un signal de brouillage sinusoïdal, et
- le pondérateur (22) effectue une pondération de l'ensemble des signaux normalisés et numérisés issus du contrôleur (21), en fonction du bit de type, grâce à une table (220) d'allocation mémorisée dans le pondérateur (22).

2. Procédé selon la revendication 1, dans lequel le bit de type est obtenu en comparant un bit d'amplitude auxiliaire (M2) filtré à un seuil de type.

3. Procédé selon l'une des revendications 1 ou 2, dans lequel la pondération est :
- une pondération d'une numérisation sur deux bits, si le bit de type est gaussien;
- une pondération d'une numérisation sur 1.5 bit, si le bit de type est sinusoïdal.

4. Procédé selon la revendication 3, dans lequel des coefficients de pondération de la table (220) d'allocation sont égaux à :
- -3, -1, +1, ou +3 pour une pondération d'une numérisation sur deux bits ; et
- -3, 0, 0, ou +3 pour une pondération d'une numérisation sur 1.5 bit.

5. Procédé selon l'une des revendications 1 à 4, dans lequel le signal (A) à large bande à étalement de spectre est un signal GPS ou GNSS, et le récepteur (100) un récepteur GPS ou GNSS.

6. Récepteur (100) adapté pour réduire un signal (B) de brouillage d'un signal (A) à large bande à étalement de spectre, comportant un système (20) de réduction du signal (B) de brouillage, ledit récepteur (100) étant **caractérisé en ce que** le système (20) comportant en outre un contrôleur (21) de gain automatique comportant
- au moins un amplificateur (211) radiofréquence (RF) et/ou au moins un amplificateur (214) de fréquence intermédiaire (FI), et une commande (216) de gain, chaque amplificateur (211, 214) ayant un gain variable commandé par la commande (216) de gain,
le contrôleur est adapté pour effectuer une normalisation en continu d'une amplitude de crête instantanée de l'ensemble des signaux entrants, à savoir le signal (A) à large bande à étalement de spectre et le signal de brouillage (B) de sorte que ladite amplitude de crête instantanée soit constante dans le temps pour l'ensemble des signaux ainsi normalisés,
- le signal (B') de brouillage normalisé étant ainsi converti en signal de brouillage sinusoïdal lorsque le signal de brouillage (B) est à bande étroite,
- le signal (B') de brouillage normalisé restant sous la forme d'un signal de brouillage gaussien lorsque le signal de brouillage (B) a une largeur de bande supérieure à une bande étroite, et **en ce que** le système (20) comporte en outre
- un convertisseur (2152) analogique/numérique adapté
pour effectuer d'une part une numérisation sur au moins deux bits de l'ensemble des signaux normalisés, à savoir élaborer un bit de signe (S) et au moins un bit d'amplitude (M), et
pour élaborer d'autre part un bit de type qui diffère selon que le signal de brouillage normalisé (B') est gaussien ou sinusoïdal,
le bit de type étant un bit gaussien lorsque le signal (B') de brouillage normalisé est sous la forme d'un signal de brouillage gaussien,
le bit de type étant un bit sinusoïdal lorsque le signal (B') de brouillage normalisé est sous la forme d'un signal de brouillage sinusoïdal, et **en ce que** le système comporte en outre
- un pondérateur (22) apte à effectuer une pondération de l'ensemble des signaux normalisés et numérisés issus du contrôleur (21), en fonction du bit de type, grâce à une table (220) d'allocation mémorisée dans le pondérateur (22).

7. Récepteur (100) selon la revendication 6, dans lequel le contrôleur (21) a une bande passante supérieure à 100 kHz.

8. Récepteur (100) selon la revendication 6, dans lequel chaque amplificateur (211, 214) a une bande passante supérieure à 100 kHz.

## Claims

1. A method for reducing a signal (B) interfering with a broadband spread-spectrum signal (A) reaching a receiver (100), the receiver (100) including a system (20) for reducing the interference signal (B) comprising:
- an automatic gain controller (21) comprising:
at least one amplifier (211, 214) and a gain control (216), and
an analog-to-digital converter (2152), and
- a weighting unit (22) placed at the output of the controller (21),
said method being **characterized in that**
- the controller (21) processes all incoming signals, i.e. the wideband spread spectrum signal (A) and the interference signal (B), and continuously carries out a normalization of an instantaneous peak amplitude of all incoming signals, so that said instantaneous peak amplitude is constant in time for the set of signals thus normalized,
- the normalized interference signal (B') being thus converted into a sinusoidal interference signal when the interference signal (B) is narrow-band,
- the normalized interference signal (B') remaining in the form of a gaussian interference signal when the interference signal (B) has a bandwidth wider than narrow-band,
- the converter (2152) of the controller (21)
carries out, on the one hand, a digitization over at least two bits of the full set of normalized signals, that is it generates a sign bit (S) and at least one amplitude bit (M), and
on the other hand, also generates a type bit which differs depending on whether the normalized interference signal (B') is gaussian or sinusoidal,
the type bit being a gaussian bit when the normalized interference signal (B') is in the form of a gaussian interference signal,
the type bit being a sinusoidal bit when the normalized interference signal (B') is in the form of a sinusoidal interference signal,
and
- the weighting unit (22) carries out a weighting of the set of normalized and digitized signals output by the controller (21), according to the type bit, thanks to an assignment table (220) stored in the weighting unit (22).

2. A method according to Claim 1, wherein the type bit is obtained by comparing a filtered auxiliary amplitude bit (M2) to a type threshold.

3. A method according to one of Claims 1 or 2, wherein the weighting is:
- a weighting of a two-bit digitizing, if the type bit is gaussian;
- a weighting of a 1.5-bit digitizing, if the type bit is sinusoidal.

4. A method according to Claim 3, wherein the weighting coefficients in the assignment table (220) are equal to:
- -3, -1, +1, or +3 for a weighting of a two-bit digitizing;
and
- -3, 0, 0, or +3 for a weighting of a 1.5-bit digitizing.

5. A method according to one of Claims 1 through 4, wherein the broadband spread-spectrum signal (A) is a GPS or GNSS signal, and the receiver (100) a GPS or GNSS receiver.

6. A receiver (100) designed to reduce the interference signal (B) of a broadband spread-spectrum signal (A), including a system (20) for reducing the interference signal (B),
the system (20) also including an automatic gain controller (21) comprising
- at least one radio frequency (RF) amplifier (211) and/or at least one intermediate frequency (IF) amplifier (214), and a gain control (216), each amplifier (211, 214) having a variable gain controlled by the gain control (216), said receiver (100) being **characterized in that**
the controller is designed to carry out a continuous normalization of an instantaneous peak amplitude of all the entering signals, i.e. the broadband spread-spectrum signal (A) and the interference signal (B), such that said instantaneous peak amplitude is constant in time for the full set of signals thus normalized
- the normalized interference signal (B') thus being converted into a sinusoidal interference signal when the interference signal (B) is narrow-band,
- the normalized interference signal (B') remaining in the form of a gaussian interference signal when the interference signal (B) has a bandwidth wider than narrow-band, and **in that** the system (20) also includes
- an analog-to-digital converter (2152) designed,
on the one hand, to carry out a digitizing over at least two bits of all the signals, i.e. creating a sign bit (S) and at least one amplitude bit (M), and
on the other hand, to create a type bit which differs depending on whether the normalized interference signal (B') is gaussian or sinusoidal,
the type bit being a gaussian bit when the normalized interference signal (B') is in the form of a gaussian interference signal,
the type bit being a sinusoidal bit when the normalized interference signal (B') is in the form of a sinusoidal interference signal, and **in that** the system also includes
- a weighting unit (22) able to carry out a weighting of the full set of normalized and digitized signals output by the controller (21), according to the type bit, thanks to an assignment table (220) stored in the weighting unit (22).

7. A receiver (100) according to Claim 6, wherein the controller (21) has a pass band wider than 100 kHz.

8. A receiver (100) according to Claim 6, wherein each amplifier (211, 214) has a pass band wider than 100 kHz.

## Patentansprüche

1. Verfahren zur Reduktion eines Störsignals (B) in einem für einen Empfänger (100) bestimmten Signal (A) großer spektraler Bandbreite,
wobei der Empfänger (100) eine Einrichtung (20) zur Verminderung des Störsignals (B) aufweist, welche aufweist:
- einen automatischen Verstärkungsregler (21), welcher
wenigstens einen Verstärker (211, 214) und eine Verstärkungsregelung (216), und
einen Analog-Digital-Wandler (2152) aufweist, und
- einen am Ausgang des Reglers (21) angeordneten Gewichter (22),
wobei das Verfahren **dadurch gekennzeichnet ist, dass**
- der Regler (21) die Gesamtheit der Eingangssignale, nämlich das Signal (A) großer spektraler Bandbreite und das Störsignal (B), verarbeitet und kontinuierlich eine Normierung der momentanen Spitzenamplitude der Gesamtheit der Eingangssignale bewirkt, so dass die momentane Spitzenamplitude für die Gesamtheit der so normierten Signale zeitlich konstant ist,
- wobei das normierte Störsignal (B') so in ein sinusartiges Störsignal umgewandelt wird, wenn das Störsignal (B) schmalbandig ist,
- wobei das normierte Störsignal (B') in Form eines Gaußschen Störsignals verbleibt, wenn das Störsignal (B) eine große Bandbreite größer als ein schmales Band hat,
- der Wandler (2152) des Reglers (21)
einerseits eine Digitalisierung der Gesamtheit der normierten Signale auf wenigstens zwei Bit bewirkt, nämlich ein Vorzeichenbit (S) und wenigstens ein Amplitudenbit (M), und
andererseits ein Artenbit erstellt, das unterschiedlich ist, je nachdem, ob das normierte Störsignal (B') Gaußsch oder sinusartig ist,
wobei das Artenbit ein Gaußsches Bit ist, wenn das normierte Störsignal (B') in Form eines Gaußschen Störsignals vorliegt,
das Artenbit ein Sinusbit ist, wenn das normierte Störsignal (B') als sinusartiges Störsignal vorliegt, und
- der Gewichter (22) eine Gewichtung der Gesamtheit der normierten und digitalisierten vom Regler (21) ausgegebenen Signale in Abhängigkeit vom Artenbit dank einer in dem Gewichter (22) gespeicherten Zuordnungstabelle (220) bewirkt.

2. Verfahren nach Anspruch 1, bei welchem das Artenbit durch Vergleich eines gefilterten Hilfs-Amplitudenbits (M2) mit einer Schwelle gewonnen wird.

3. Verfahren nach einem der Ansprüche 1 oder 2, bei welchem die Gewichtung
- eine Gewichtung einer Digitalisierung auf zwei Bit, wenn das Arten-Bit Gaußsch ist,
- eine Gewichtung einer Digitalisierung auf 1,5 Bit, wenn das Artenbit sinusartig ist, ist.

4. Verfahren nach Anspruch 3, bei welchem die Gewichtungskoeffizienten der Zuordnungstabelle (220) gleich
- -3, -1, +1 oder +3 für eine Gewichtung einer Digitalisierung auf zwei Bit, und
- -3, 0, 0 oder +3 für eine Gewichtung einer Digitalisierung auf 1,5 Bit ist.

5. Verfahren nach einem der Ansprüche 1 bis 4, bei welchem das Signal (A) großer spektraler Bandbreite ein GPS- oder ein GNSS-Signal ist und der Empfänger (100) ein GPS- oder GNSS-Empfänger ist.

6. Empfänger (100), der für eine Reduktion eines Störsignals (B) eines Signals (A) großer spektraler Bandbreite eingerichtet ist, wobei der Empfänger eine Einrichtung (20) zur Reduktion eines Störsignals (B) aufweist, wobei die Einrichtung (20) ferner einen automatischen Verstärkungsregler (21) aufweist, welcher
- wenigstens einen Verstärker (211) für Hochfrequenz (RF) und/oder wenigstens einen Verstärker (214) für eine Intermediärfrequenz (FI) und eine Verstärkungsregelung (216) aufweist, wobei jeder Verstärker (211, 214) eine von der Verstärkungsregelung (216) geregelte variable Verstärkung hat, wobei der Empfänger (100) **dadurch gekennzeichnet ist, dass**
der Regler eingerichtet ist, eine kontinuierliche Normierung einer momentanen Spitzenamplitude der Gesamtheit der Ausgangssignale, nämlich des Signals (A) großer spektraler Bandbreite und des Störsignals (B), durchzuführen, so dass die momentane Spitzenamplitude für die Gesamtheit der so normierten Signale zeitlich konstant ist,
- wobei das normierte Störsignal (B') so in ein sinusartiges Störsignal umgewandelt wird, wenn das Störsignal (B) schmalbandig ist, und
- wobei das normierte Störsignal (B') in Form eines Gaußschen Störsignals verbleibt, wenn das Störsignal (B) eine Bandbreite hat, die größer als ein schmales Band ist, und **dadurch**, dass die Einrichtung (20) ferner
einen Analog-Digital-Wandler (2152) aufweist, der eingerichtet ist,
einerseits eine Digitalisierung der Gesamtheit der normierten Signale auf wenigstens zwei Bit zu bewirken, nämlich ein Vorzeichenbit (S) und wenigstens ein Amplitudenbit (M) zu erstellen, und
andererseits ein Artenbit zu erstellen, welches unterschiedlich ist, je nachdem, ob das normierte Störsignal (B') Gaußsch oder sinusartig ist,
wobei das Artenbit ein Gaußsches Bit ist, wenn das normierte Störsignal (B') in Form eines Gaußschen Störsignals vorliegt,
das Artenbit ein Sinusbit ist, wenn das normierte Störsignal (B') in Form eines sinusartigen Störsignals vorliegt, und **dadurch**, dass die Einrichtung ferner aufweist:
- einen Gewichter (22), der eingerichtet ist, eine Gewichtung der Gesamtheit der normierten und digitalisierten vom Regler (21) ausgegebenen Signale in Abhängigkeit vom Artenbit dank einer in dem Gewichter (22) gespeicherten Zuordnungstabelle (220) durchzuführen.

7. Empfänger (100) nach Anspruch 6, bei welchem der Regler (21) eine Bandbreite von mehr als 100 kHz hat.

8. Empfänger nach Anspruch 6, bei welchem jeder Verstärker (211, 214) eine Bandbreite von mehr als 100 kHz hat.
